Europäisches Patentamt

European Patent Office

Office européen des brevets

(19)

(11) Numéro de publication: **0 346 204**

**A1**

**(12)**

# DEMANDE DE BREVET EUROPEEN

(21) Numéro de dépôt: **89401543.7**

(22) Date de dépôt: **05.06.89**

(51) Int. Cl.⁴: **G 01 R 1/10**

(30) Priorité: **06.06.88 FR 8807488**
**03.05.89 FR 8905899**

(43) Date de publication de la demande:
**13.12.89 Bulletin 89/50**

(84) Etats contractants désignés:
**AT BE CH DE ES GB GR IT LI LU NL SE**

(71) Demandeur: **RADIO CONTROLE S.A.**
**13, rue Clément Boyer**
**F-69000 Lyon (Rhone)  (FR)**

(72) Inventeur: **Palencher, Jacques**
**26, rue Général Saussier**
**Troyes (Aube)  (FR)**

**Jaillant, Gabriel**
**Route de Brienne**
**Creney Pont Sainte Marie (Aube)  (FR)**

(74) Mandataire: **Cabinet Pierre HERRBURGER**
**115, Boulevard Haussmann**
**F-75008 Paris  (FR)**

(54) **Appareil de mesure d'une grandeur électrique.**

(57)   Appareil de mesure d'une grandeur électrique, comportant un corps fixe (1) et un équipage mobile (6) dont l'axe pivotant (7) est solidaire d'une aiguille indicatrice (8) se déplaçant devant un cadran gradué (9), appareil caractérisé en ce que l'équipage mobile est monté pivotant sur le corps fixe, d'une part, par des pointes de pivotage (13, 14) et des portées d'appui correspondantes (15, 16) prévues, les unes aux extrémités de l'axe (7), les autres en regard sur le corps fixe (2), d'autre part par des couteaux (17, 18) et des portées d'appui correspondantes fixées les uns sur le corps, les autres à proximité des extrémités de l'axe (7), le tranchant ($17_1$, $18_1$) des couteaux et les pointes de pivotage ainsi que les portées correspondantes, étant alignés.

FIG.1

EP 0 346 204 A1

Description

## Appareil de mesure d'une grandeur électrique.

L'invention concerne un appareil de mesure d'une grandeur électrique.

La sensibilité et la précision des appareils à équipage mobile pour la mesure d'une grandeur électrique, dépendent pour une grande part, du mode de pivotage mis en oeuvre.

Ce pivotage est couramment réalisé par des pointes de pivotage formées à l'extrémité de l'axe de l'équipage mobile et qui viennent s'appliquer sur des portées correspondantes formées en regard l'une de l'autre sur le corps de l'appareil.

Cependant, ce mode de pivotage ne peut être considéré comme excellent que s'il s'agit d'appareils à lecture horizontale, c'est-à-dire à axe vertical et que si les pointes de pivotage et les parties correspondantes sont réalisées en métal.

Afin de réduire les coûts, on cherche cependant actuellement à réaliser des appareils de mesure de grandeur électrique dont la grande majorité des pièces constitutives et, notamment, l'équipage mobile, est réalisée en matière plastique, cet appareil de mesure devant en outre présenter une bonne précision et une bonne sensibilité, qu'il s'agisse d'un appareil à lecture horizontale ou d'un appareil à lecture verticale, c'est-à-dire un appareil de mesure dit ''de tableau''.

La présente invention a notamment pour but de remédier à ces inconvénients et concerne à cet effet un appareil de mesure d'une grandeur électrique comportant un corps fixe et un équipage mobile dont l'axe pivotant est solidaire d'une aiguille indicatrice se déplaçant devant un cadran gradué, appareil caractérisé en ce que l'équipage mobile est monté pivotant sur le corps fixe, d'une part, par des pointes de pivotage et des portées d'appui correspondantes prévues, les unes aux extrémités de l'axe, les autres en regard sur le corps fixe, d'autre part par des couteaux et des portées d'appui correspondantes fixées les uns sur le corps, les autres à proximité des extrémités de l'axe, le tranchant des couteaux et les pointes de pivotage ainsi que les portées correspondantes, étant alignés.

Suivant une autre caractéristique de l'invention, les deux couteaux ou leur portée d'appui, sont réalisés en une seule et même pièce se disposant sur le corps fixe de l'appareil.

Suivant une autre caractéristique de l'invention, le corps fixe constitue une bobine dont le fût creux reçoit à pivotement l'équipage mobile, la pièce formant les couteaux ou leur portée d'appui constituant un étrier fixé sur la paroi interne de ce fût creux.

L'invention est représentée à titre d'exemple non limitatif sur les dessins ci-joints dans lesquels :

- la figure 1 est une vue en coupe axiale d'un appareil conforme à l'invention,
- la figure 2 est une vue de dessus de la figure 1, la raquette étant ôtée et l'équipage mobile étant représenté en pointillés,
- la figure 3 est une vue latérale de l'équipage mobile de l'appareil de la figure 1,
- les figures 4 et 5 sont des vues en coupe suivant A-A et B-B de la figure 3,
- la figure 6 est une vue en perspective de l'étrier formant les portées d'appui des couteaux dans l'exemple de réalisation des figures 1 et 2,
- la figure 7 est une vue en perspective d'un autre mode de réalisation de l'étrier de la figure 6.

La présente invention a en conséquence pour but la réalisation d'un appareil de mesure d'une bonne sensibilité et d'une grande précision, dont la quasi-totalité des pièces constitutives et, notamment, les organes de pivotage, peut être réalisée en matière plastique, cet appareil pouvant être utilisé indifféremment en position horizontale ou verticale.

Le corps de l'appareil représenté sur les dessins ci-joints se compose essentiellement d'une bobine 1, dont le fût 2 est creux et est solidaire de l'un des flasques 3, l'autre flasque 4 étant encliqueté en 5 à l'autre extrémité du fût 2. Cette bobine, qui constitue le support d'un enroulement non représenté de fil métallique, est réalisée par moulage d'une matière plastique.

A l'intérieur du fût creux 2 de la bobine, est monté à pivotement l'équipage mobile 6 qui se compose essentiellement d'un axe 7 solidaire d'une aiguille indicatrice 8 se déplaçant devant un cadran gradué 9.

Le rappel en position zéro de l'aiguille 8 de l'équipage mobile est assuré par un ressort spirale 10 dont l'extrémité interne est solidarisée de l'axe 7 et dont l'extrémité externe est solidarisée d'une raquette en matière plastique 11. Cette raquette est assemblée par un montage à baïonnette 12 à l'extrémité du fût 2, afin que le pivotement de cette raquette 11 suivant l'axe X-X du fût 2, permette d'effectuer le réglage de la position zéro de l'aiguille 8 devant le cadran gradué.

Le pivotement de l'équipage mobile est assuré par un double mode de pivotage comprenant, d'une part, des pointes de pivotage, d'autre part, des couteaux.

Ainsi, sur les figures ci-jointes, l'axe 7 de l'équipage mobile est pourvu à ses extrémités de pointes de pivotage à extrémités coniques 13 et 14. La pointe 13 se place dans un logement 15 de forme générale conique réalisée dans la raquette 11. La pointe de pivotage 14 se place dans un logement 16 de forme générale cylindrique, en venant en appui contre la portée conique $16_1$ de l'extrémité de ce logement cylindrique 16.

Par ailleurs, l'axe 7 est pourvu, à proximité de ses extrémités, de deux couteaux 17 et 18 dont les tranchants $17_1$, $18_1$ sont en appui contre les arêtes $19_1$ des portées d'appui en forme de dièdre 19 venues de moulage lors de la réalisation d'une pièce en matière plastique en forme d'étrier 20. Cette pièce 20 présente deux rebords parallèles 21 et 22 réalisés de manière à pouvoir s'appuyer sur des nervures, respectivement 23 et 24, formées en saillie sur la paroi interne du fût 2 parallèlement à l'axe X-X.

Cet étrier 20 est par ailleurs réalisé de façon que les arêtes $19_1$ des dièdres 19 soient situées exactement suivant l'axe X-X du fût 2, c'est-à-dire suivant l'alignement des pointes de pivotage 13, 14 lorsque cet étrier 20 est positionné entre les nervures 23, 24.

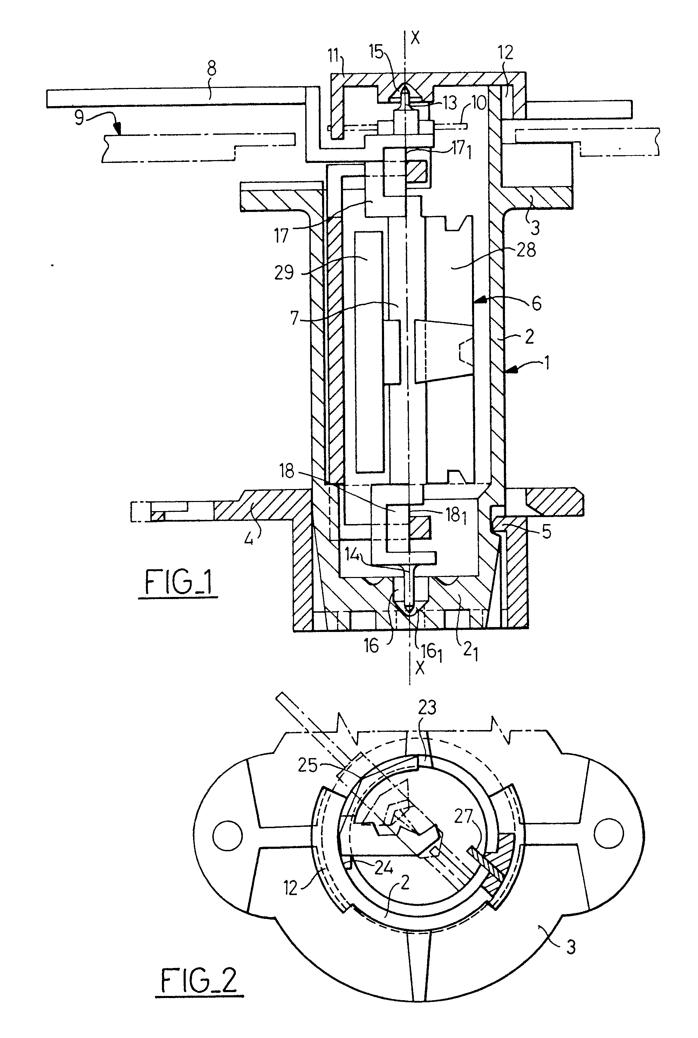

Suivant le mode de réalisation représenté sur la figure 2, une troisième nervure 25 est prévue en saillie sur la paroi interne du fût 2 entre les nervures 23, 24. Cette nervure 25 est destinée à recevoir en appui une arête 26 de l'étrier 20 afin de positionner rigoureusement les arêtes $19_1$ des dièdres 19 suivant l'axe X-X du fût 2.

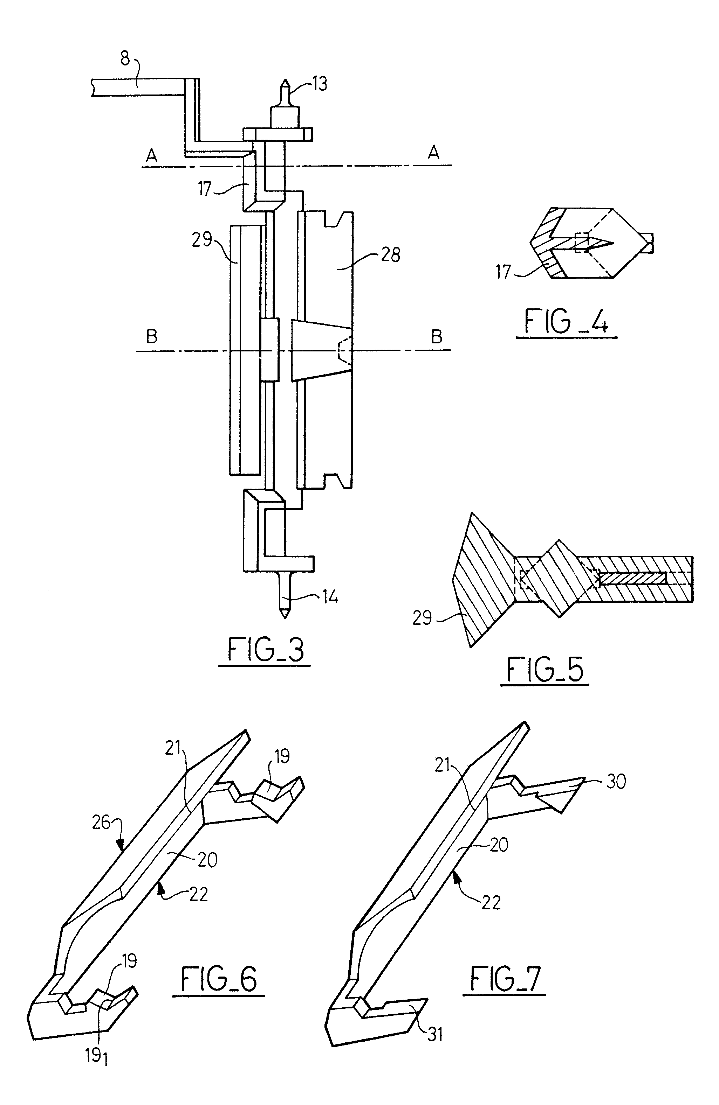

Suivant le mode de réalisation de la figure 7, l'étrier 20 est pourvu de deux surfaces planes 30 et 31 qui remplacent les dièdres 19 de la figure 6.

La mise en oeuvre de surfaces planes 30 à 31 pour constituer les surfaces d'appui des tranchants $17_1$, $18_1$ des couteaux 17, 18, permet d'améliorer la sensibilité de l'appareil et d'améliorer sa précision en annulant les effets nuisibles des défauts d'alignement, même mineurs, qui peuvent exister à la fabrication entre les pointes de pivotage 13, 14, les logements 15, 16, le tranchant des couteaux 17, 18 et ses surfaces 30 et 31.

De préférence également, ces surfaces 30 et 31 sont orientées dans le fût 1, de façon que la perpendiculaire à ces surfaces passe sensiblement par le milieu de la graduation 9 de l'appareil de mesure.

Dans les exemples représentés, l'appareil de mesure est un appareil ferromagnétique et le fût 2 de la bobine comporte une palette métallique 27 avec laquelle coopère la palette métallique 28 solidaire de l'axe 7. Cet axe 7, réalisé également en matière plastique, comporte, venus de moulage, non seulement l'aiguille 8 mais également un contre-poids 29 équilibrant notamment le poids de la palette 28.

On constate donc que, suivant la construction décrite, l'équipage mobile comporte un double mode de pivotage comprenant, d'une part, des pointes de pivotage 13, 14, d'autre part des couteaux 17, 18, de façon à construire un appareil dont l'essentiel des pièces constitutives est en matière plastique et qui possède une bonne sensibilité, quelle que soit la position de l'appareil de mesure.

On notera également que, sur le plan constructif, les arrondis formant l'extrémité ou le sommet des pointes 13, 14, des portées 15, 16, des couteaux 17, 18 et des dièdres 19, seront déterminés à chaque fois en fonction de la matière plastique mise en oeuvre et, notamment, en fonction de sa dureté.

Egalement, afin d'amortir le pivotement de l'aiguille 8, un produit visqueux pourra être disposé à l'intérieur du logement 16 afin de coopérer avec la pointe de pivotage 14 pour ralentir le pivotement de l'équipage mobile 6.

## Revendications

1) Appareil de mesure d'une grandeur électrique, comportant un corps fixe (1) et un équipage mobile (6) dont l'axe pivotant (7) est solidaire d'une aiguille indicatrice (8) se déplaçant devant un cadran gradué (9), appareil caractérisé en ce que l'équipage mobile est monté pivotant sur le corps fixe, d'une part, par des pointes de pivotage (13, 14) et des portées d'appui correspondantes (15, 16) prévues, les unes aux extrémités de l'axe (7), les autres en regard sur le corps fixe (2), d'autre part par des couteaux (17, 18) et des portées d'appui correspondantes (19) fixées les uns sur le corps, les autres à proximité des extrémités de l'axe (7), le tranchant ($17_1$, $18_1$) des couteaux et les pointes de pivotage ainsi que les portées correspondantes, étant alignés.

2) Appareil conforme à la revendication 1, caractérisé en ce que les couteaux (17, 18) ou leur portée d'appui, sont réalisés en une seule et même pièce se disposant sur le corps fixe de l'appareil.

3) Appareil conforme à l'une quelconque des revendications précédentes, caractérisé en ce que le corps fixe constitue une bobine dont le fût creux (2) reçoit à pivotement l'équipage mobile, la pièce (20) formant les couteaux ou leur portée d'appui constituant un étrier fixé sur la paroi interne de ce fût creux.

4) Appareil conforme à l'une quelconque des revendications précédentes, caractérisé en ce que les portées recevant en appui le tranchant ($17_1$, $18_1$) des couteaux (17, 18), sont constituées par des surfaces planes (30, 31).

5) Appareil selon la revendication 4, caractérisé en ce que la perpendiculaire aux surfaces planes passe sensiblement par le milieu de la graduation de l'appareil de mesure.

FIG_1

FIG_2

FIG_3

FIG_4

FIG_5

FIG_6

FIG_7

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | DE-A-2 209 643 (NEUBERGER MESSINSTRUMENTE) --- | | G 01 R 1/10 |
| A | FR-A-2 357 867 (RIVOIR) ----- | | |

DOMAINES TECHNIQUES RECHERCHES (Int. Cl.4)

G 01 R

Le présent rapport a été établi pour toutes les revendications

| Lieu de la recherche | Date d'achèvement de la recherche | Examinateur |
|---|---|---|
| LA HAYE | 18-09-1989 | HOORNAERT W. |